# EUROPEAN PATENT APPLICATION

(11) **EP 1 289 154 A1**
(43) Date of publication of application: **05.03.2003**
(21) Application number: 01930246.2
(22) Date of filing: 22.05.2001
(51) Int. Cl.: H03M 13/27, H04L 1/00

(54) **ADDRESS CONVERTER, INTERLEAVER AND DE-INTERLEAVER**

(30) Priority: 22.05.2000 JP 2000150360
(71) Applicant: Yozan Inc., Tokyo 155-0031 (JP)
(72) Inventor: FUKUI, Masataka, Setagaya-ku, Tokyo 155-0031 (JP); SUZUKI, Kunihiko, Setagaya-ku, Tokyo 155-0031 (JP); ZHOU, Changming, Setagaya-ku, Tokyo 155-0031 (JP)
(74) Representative: Grünecker, Kinkeldey, Stockmair & Schwanhäusser Anwaltssozietät
(86) International application number: JP0104283
(87) International publication number: WO01091308

(57) **Abstract**

An object of the present invention is to provide an interleaver and a deinterleaver, which are small-sized and power saving. An address converter ACON has three counters CNT1, CNT2 and CNT3 in associated with a first rank through a third rank and the outputs DO11, DO12 and DO13 of respective counters CNT1, CNT2 and CNT3 are inputted in lookup tables LUT1, LUT2 and LUT3. In the counter CNT3, a clock CK1 with a predetermined cycle is inputted and the numeric values of "0" through "3" are repeatedly outputted. In the counter CNT2, a carry out CO3 to be outputted in synchronization with the output of the counter CNT3, i.e., "0" is inputted as a clockCK2. Further, the counter CNT2 outputs the numeric values of "0" through "4" repeatedly. In the counter CNT1, a carry out CO2 to be outputted in synchronization with the output of the counter CNT2, i.e., "0" is inputted as a clock CK3. Further, the counter CNT1 outputs the numeric values of "0" through "15" repeatedly.

## Description

### TECHNICAL FIELD

The present invention relates to an address converter, an interleaver and a deinterleaver in a digital communication.

### BACKGROUND ART

As a method for decreasing an effect of a noise against transmission data, the interleaving is known where an order of respective bits of data is evenly blended and a bit row is transmitted after its order has been blended. At a receiving side, the deinterleaving is performed to return the blended data to its original order so as to reproduce the data. Therefore, it is prevented that the bit row is concentrated and deteriorated, so that it becomes easy to reproduce the data. Then, the longer the length of a unit for the data to be blended becomes, the more it is possible to decrease the effect of the noise. However, in order to perform this interleaving and this deinterleaving, a lookup table to indicate a data blending state is needed, and the longer the data unit to be blended is, the larger lookup table is needed.

In this case, upon blending the data, an algorithm is prevailing such that plural blending data address row patterns are generated in advance, an initial address row is converted into plural lines of a two-dimensional matrix, the operation is repeated to further convert each line of this matrix into the plural lines of the two-dimensional matrix, the operation is repeated to sequentially generate the two-dimensional matrix which is lower by one rank and this operation is terminated when the two-dimensional matrix converges on a blending data address row pattern, so that a blending address is generated.

### DISCLOSURE OF THE INVENTION

In a mobile communication, which has been rapidly widespread in recent years, the interleaving and the deinterleaving are also indispensable. However, if a mobile station is provided with a large-sized lookup table, this causes a serious problem such that the electric power consumption is increased and the circuit size becomes larger.

The present invention has been made under the above mentioned background, and the object is to provide an address converter, an interleaver and a deinterleaver, which serve for interleaving and deinterleaving and are small-sized and power saving.

According to the present invention, an address converter comprises an upper rank lookup table to sequentially output not more than m pieces of elements equivalent to a predetermined line of a m×n matrix having the number of the elements not less than the length of a predetermined address data row; a lower rank lookup table to sequentially and repeatedly output n pieces of elements equivalent to the predetermined row of the m×n matrix not more than m times; and an adder to add the output of the upper rank lookup table and the output of the lower rank lookup table and output the predetermined address data row. Therefore, a large-sized lookup table is not necessary and it is possible to generate a blending address by a small-sized circuit.

The address converter further comprises with a multiplier to multiply the output with m and input it in the adder instead of directly inputting the output of the lower rank lookup table in the adder. As a result, decreasing a numeric value which is outputted from a lower rank lookup table enables the number of the bits to be stored in a lower rank lookup table to be decreased.

The adder adds the outputs of not less than three lookup tables. As a result, it is possible to make a size of the lookup table smaller.

The interleaver according to the present invention comprises the address converter, a first register to hold a data row to be blended, and a second register to register a data row of the first register in an order of the blending address data row on the basis of the blending address data row when an initial address data row is inputted in the address converter and a circuit size thereof is small.

The deinterleaver according to the present invention, comprises the address converter, a second register to hold a data row to be blended, and a first register to register a data row of the second register in an order of the initial address data row on the basis of the blending address data row when the initial address data row is inputted in the address converter and a circuit size thereof is small.

The present specification includes the specification and/or the drawings of Japanese Patent Application No. 2000-150360, on which a priority of the present application bases.

### BRIEF DESCRIPTION OF THE DRAWINGS

FIG. 1 is a block diagram for illustrating a concept of data blending by an interleaver according to the present invention;
FIG. 2 is a block diagram for illustrating a concept of data reconstruction by a deinterleaver according to the present invention;
FIG. 3 is a block diagram for illustrating an address converter of an embodiment of an interleaver according to the present invention;
FIG. 4 is a conceptual illustration for illustrating a principle of the address conversion by the address converter shown in FIG. 3;
FIG. 5 is a timing diagram for illustrating a clock cycle of respective counters by the address converter shown in FIG. 3 and a cycle of an address data row of the lowest rank;
FIG. 6 is a block diagram for illustrating an address converter according to other embodiment of the interleaver according to the present invention;
FIG. 7 is a conceptual illustration for illustrating a matrix layer to show a principle of the address conversion shown in FIG. 3;
FIG. 8 is a conceptual illustration for illustrating a matrix layer to show a principle of other address conversion;
FIG. 9 is a conceptual illustration for illustrating a matrix layer to show a principle of other address conversion;
FIG. 10 is a conceptual illustration for illustrating a matrix layer to show a principle of other address conversion;
FIG. 11 is a conceptual illustration for illustrating a matrix layer to show a principle of other address conversion;
FIG. 12 is a conceptual illustration for illustrating a matrix layer to show a principle of other address conversion;
FIG. 13 is a conceptual illustration for illustrating a matrix layer to show a principle of other address conversion;
FIG. 14 is a conceptual illustration for illustrating a matrix layer to show a principle of other address conversion;
FIG. 15 is a conceptual illustration for illustrating a matrix layer to show a principle of other address conversion;
FIG. 16 is a conceptual illustration for illustrating a matrix layer to show a principle of other address conversion;
FIG. 17 is a conceptual illustration for illustrating a matrix layer to show a principle of other address conversion;
FIG. 18 is a conceptual illustration for illustrating a matrix layer to show a principle of other address conversion; and
FIG. 19 is a conceptual illustration for illustrating a matrix layer to show a principle of other address conversion.

### DESCRIPTION OF REFERENCE NUMERALS

C1, C2, C3, C4, C5: cycle (data length)
ACON: address converter
LUT1, LUT2, LUT3, LUT4, LUT5: lookup table
MUL1, MUL2, MUL3, MUL4: multiplier
ADD: adder
DREG1: first resister
DREG2: second resister
INT: interleaver
DINT: deinterleaver

### BEST MODE FOR CARRYING OUT THE INVENTION

In the next place, an embodiment of an interleaver and a deinterleaver according to the present invention will be explained with reference to the drawings.

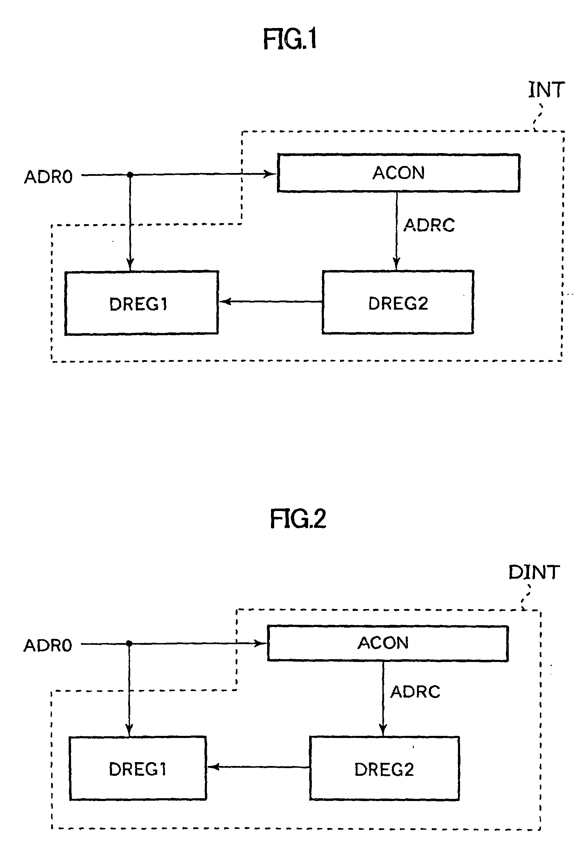

FIG. 1 is a block diagram for illustrating a concept of data blending by an interleaver according to the present invention and FIG. 2 is a block diagram for illustrating a concept of data reconstruction by a deinterleaver according to the present invention.

In FIG. 1, an interleaver INT is provided with an address converter ACON, in which an initial address data row ADR0 comprising of a continuous address data such as 0, 1, 2, ... or the like is inputted, a first register DREG1 which holds a data row to be blended and a second resister DREG2 which registers a data row of the first register DREG1 on the basis of a blending address data row ADRC to be outputted from the address converter ACON in the order of the blending address data row ADRC. The initial address data row ADR0 is also inputted in the first register DREG1 and the data within the first register DREG1 is read out in the order of the initial address data row ADR0. On the other hand, the second resister DREG2 writes the data which has been read out from the first register DREG1 in an address, which is designated by the blending address data row ADRC in the second resister DREG2. The data blending has been performed in this way.

In FIG. 2, a deinterleaver DINT is provided with an address converter ACON, which is the same as the address converter ACON shown in FIG. 1, a second register DREG2 which holds the blended data row and a first register DREG1 which registers the data row of the second register DREG2 in the order of the initial address data row ADR0 on the basis of the blended address data row ADRC in the case that the initial address data row ADR0 has been inputted in the address converter. Alternatively, a circuit size of the deinterleaver shown in FIG. 2 is rather small. The initial address data row ADR0 is also inputted in the first register DREG1 and the data within the second register DREG2 is read out in the order of the blended address data row ADRC. On the other hand, the first register DREG1 writes the data which has been read out from the second register DREG2 in an address, which is designated by the initial address data row ADR0 in the first resister DREG1. In this way, the data, which has been blended, is newly arranged in the order of the initial address data row so as to be reproduced.

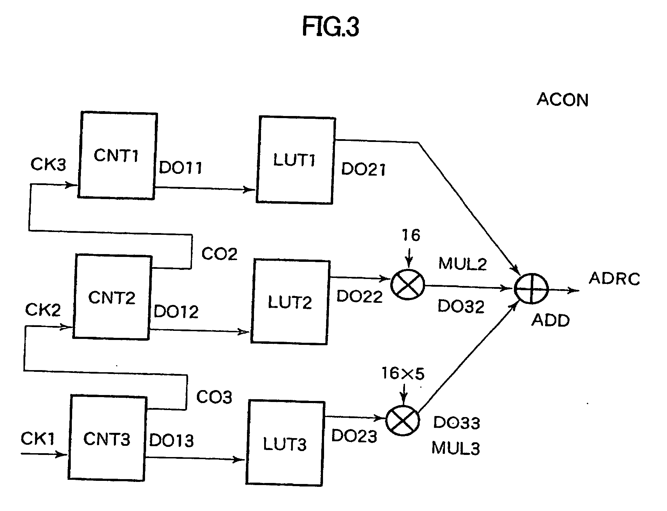

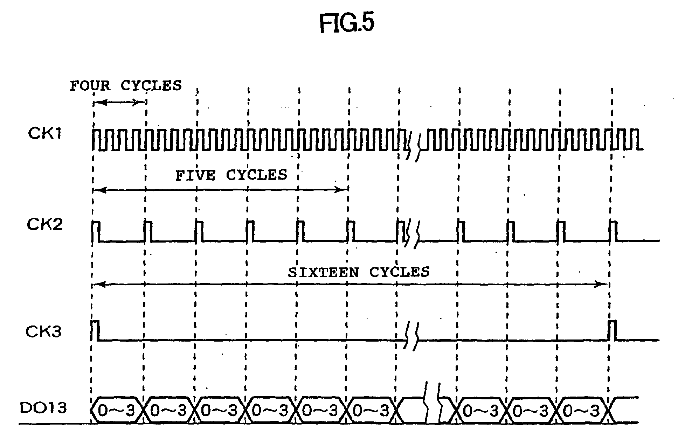

FIG. 3 is a block diagram for illustrating an example of the address converter shown in FIG. 1 and FIG. 2, FIG. 4 is a conceptual illustration for illustrating a principle of the address conversion by the address converter shown in FIG. 3 and FIG. 5 is a timing diagram for illustrating a clock and the output data of the address converter shown in FIG. 3.

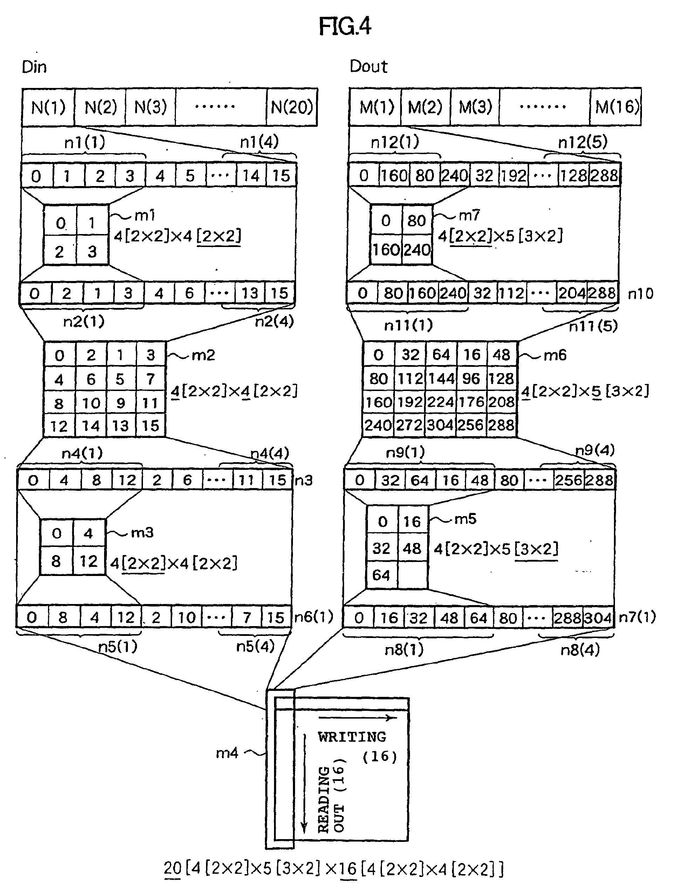

FIG. 4 shows an example of the blending of the data Din of 320 bits. At first, the data Din of 320 bits is divided into twenty pieces of the data rows N(1), N(2), ..., N(20), which are comprised of 16 bits, respectively. In the case of the data row N(1), for example, the data of 16 bits is divided into four data rows n1(1) through n1(4), which are comprised of 4 bits, respectively. In the next place, the data of the data row n1(1) is arranged in series in a line direction within a 2×2 matrix m1. Then, by reading this in a column direction, a data row n2(1) of 4 bits is generated. The same case applies to other data rows n1(2) through n1(4). The data row of 16 bits, in which the data rows n2(1) through n2(4) are arranged in series, is arranged in series in a line direction within a 4×4 matrix m2. Then, by reading out this in a column direction, a data row n3 of 16 bits is generated. The data n3 of 16 bits is divided into four data rows n4(1) through n4(4), which are comprised of 4 bits, respectively and the data of respective data rows is arranged in series in a line direction within a 2×2 matrix m3. Then, by reading out this in a column direction, the data rows n5(1) through n5(4) of 4 bits are generated. The same case is applied to other data rows N(2) through N(20). A data row of 16 bits, in which the data rows n5(1) through n5(4) are arranged in series, is defined as n6(1) and the same data rows corresponding to N(2) through N(20) are defined as n6(2) through n6(20).

A 20×16 matrix m4 having the data rows n6(1) through n6(20) as respective lines is generated. Then, by reading this in a column direction, 16 pieces of data rows n7(1) through n7(16) of 20 bits are generated. In the case of the data row n7(1), the data of 20 bits is divided into four data rows n8(1) through n8(4), which are comprised of 5 bits, respectively. In the next place, the data of the data row n8(1) is arranged in series in a line direction within a 2×3 matrix m5. Then, by reading this in a column direction, a data row n9(1) of 5 bits is generated. The same case applies to other data rows n8(2) through n8(4). The data row of 20 bits, in which the data rows n9(1) through n9(4) are arranged in series, is arranged in series in a line direction within a 4×5 matrix m6. Then, by reading out this in a column direction, a data row n10 of 20 bits is generated. The data n10 of 20 bits is divided into five data rows n11(1) through n11 (5) , which are comprised of 4 bits, respectively and the data of respective data rows is arranged in series in a line direction within a 2×2 matrix m7. Then, by reading out this in a column direction, the data rows n12(1) through n12(5) of 4 bits are generated and a data row M(1), in which the data rows n12(1) through n12(5) are arranged in series, is generated. The same case is applied to other data rows n7(2) through n7(16). The same data rows corresponding to n7(2) through n7(16) are defined as M (2) through M(16). Then, a bit data row of 320 bits, in which the data rows M(1) through M(16) are arranged in series, is defined as the blending data Dout.

Upon writing in the matrix line direction and reading out in the line direction, plural address rows are generated in such a manner that plural addresses, which are separated by a certain rule, the addresses in which the above addresses are shifted by a certain number of addresses, and the addresses in which these addresses are further shifted by a certain number of addresses and then, these plural address rows are arranged in series. In the M(1), among plural address rows, a first address row comprises "0, 160, 80, 240", a second address row comprises "32, 192, 112, 272", which are obtained by adding the address "32" to "0, 160, 80, 240", a third address row comprises "64, 224, 144, 304", which are obtained by adding the address "32" to "32, 192, 112, 272", a fourth address row comprises "16, 176, 96, 256", which are obtained by subtracting the address "48" from "64, 224, 144, 304" and a fifth address row comprises "48, 208, 128, 288", which are obtained by adding the address "32" to "16, 176, 96, 256". The M(1) is comprised in such a manner that these address rows are arranged in series.

In the M(2) through the M(16), the first addresses of the first address rows thereof are "8", "4", "12", "2", "10", "6", "14", "1", "9", "5", "13", "3", "11", "7" and "15", respectively, so that the addresses of the M(2) through the M(16) are defined by the same rule as that of the M(1).

The blending data Dout is configured in such a manner that respective bits of the data Din are taken in predetermined spacing to be sequentially assigned within respective data rows M(1) through M(16). Further, the arrangement within respective data rows M(1) through M(16) is based on a predetermined rule. This rule is capable of being defined by a combination of the rules of the shorter and lower ranks, sequentially. For example, when the data row Dout of 320 bits is defined as the first rank, the second rank is a data row M(i) of 20 bits and the third rank is a data row n12(i) of 4 bits.

In FIG. 3 and FIG. 5, the address converter ACON has three counters CNT1, CNT2 and CNT3, which correspond to the first rank through the third rank, and the outputs DO11, DO12 and DO13 of respective counters CNT1, CNT2 and CNT3 are inputted in lookup tables LUT1, LUT2 and LUT3. A clock CK1 of a predetermined cycle is inputted in a counter CNT3 and the numeric values of "0" through "3" are repeatedly outputted. This cycle corresponds to a data cycle of the data row n12(i) shown in FIG. 4. An output carry out CO3 to be outputted in synchronized with the output of the counter CNT3, i.e., "0" is inputted in a counter CNT2 as a clock CK2 and the counter CNT2 repeatedly outputs the numeric values of "0" through "4". In other words, the counter CNT2 defines the twenty clocks of the clock CK1 as a cycle. This cycle corresponds to a data cycle of a data row n10 in FIG. 4, namely, five pieces of the 4 bit data. An output carry out C02 to be outputted in synchronized with the output of the counter CNT2, i.e., "0" is inputted in a counter CNT1 as a clock CK3 and the counter CNT1 repeatedly outputs the numeric values of "0" through "15". In other words, the counter CNT1 defines 320 clocks of the clock CK1 as a cycle. This number of the bits is the same as the number of the bits of the initial address data row ADR0 and the blending address data row ADRC. Alternatively, this cycle corresponds to the data cycle of the Dout shown in FIG. 4, namely, 16 pieces of the data of 20 bits.

The lookup table LUT3 converts the data arrangement rule of the data row n12(1). In other words, the lookup table LUT3 converts the addresses of "0" through "3" into "0, 2, 1, 3". The lookup table LUT2 converts the data arrangement rule of the data row n9(1). In other words, the lookup table LUT2 converts the addresses of "0" through "4" into "0, 2, 4, 1, 3". The lookup table LUT1 converts the data arrangement rule of the data row n 6. In other words, the lookup table LUT1 converts the addresses of "0" through "15" into "0, 8, 4, 12, 2, 10, 6, 14, 1, 9, 5, 13, 3, 11, 7, 15".

As a result, while an output DO21 outputs "0, 8, 4, 12, 2, 10, 6, 14, 1, 9, 5, 13, 3, 11, 7, 15" once with 320 (=16 ×5×4) clocks of the CK1 as a cycle, an output DO22 outputs "0, 2, 4, 1, 3" sixteen times with 20 (=5×4) clocks of the CK1 as a cycle and an output DO23 outputs "0, 2, 1, 3" eighty (=16 ×5) times with four clocks of the CK1 as a cycle.

The outputs DO22 and DO23 of the lookup tables LUT2 and LUT3 are inputted in multipliers MUL2 and MUL3, respectively. The multiplier MUL2 multiplies the output DO22 with "16" as a cycle of the output carry out CO2 and then, the multiplier MUL3 multiplies the output DO23 with a value obtained by multiplying this "16" with "5" as a cycle of the output carry out CO3.

As a result, while an output DO21 of the lookup table LUT1 outputs "0, 8, 4, 12, 2, 10, 6, 14, 1, 9, 5, 13, 3, 11, 7, 15" once with 320 (=16×5×4) clocks of the CK1 as a cycle, an output DO32 of the multiplier MUL2 outputs "0, 32, 64, 16, 48" sixteen times with 20 (=5×4) clocks of the CK1 as a cycle and an output DO33 of the multiplier MUL3 outputs "0, 160, 80, 240" eighty (=16×5) times with four clocks of the CK1 as a cycle.

The outputs DO32 and DO33 of the multiplier MUL2 and the multiplier MUL3 and the output DO21 of the lookup table LUT1 are inputted in an adder ADD to be added and then, they are outputted as the blending address data row ADRC.

In this case, considering the outputs DO32 and DO33 of the multiplier MUL2 and the multiplier MUL3, a first line of m×n matrix (m=4 lines, n=5 rows) is comprised of "0, 32, 64, 16, 48"and a first row is comprised of "0, 160, 80, 240". Further, respective elements of the matrix obtained by adding the elements in the first line and the first row, which correspond to each other, are sequentially read out from (1, 1) in a line direction and a column direction to be outputted. In other words, "0, 160, 80, 240", "32, 192, 112, 272", "64, 224, 144, 304", "16, 176, 96, 256" and "48, 208, 128, 288" are sequentially outputted.

The data capacities of the lookup tables LUT1 through LUT3 are only 87 bits (4×16+3×5+2×4). Therefore, compared to the lookup table of 2.9 K bits (9×320) to convert all addresses of 320 bit data, the sizes of the lookup tables LUT1 through LUT3 are extremely smaller.

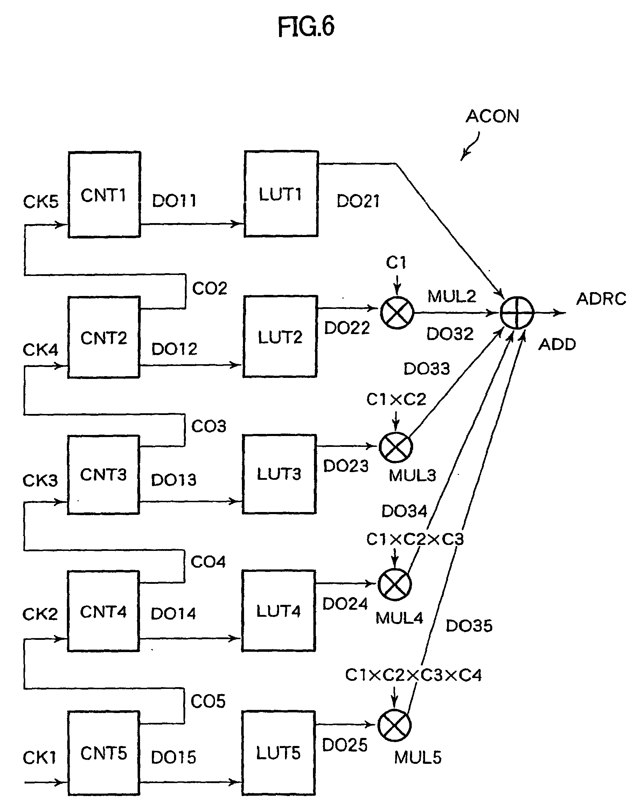

FIG. 6 illustrates an example of the address converter ACON such that the blending address data row ADRC is divided into the data rows from a first rank to a fifth rank and respective arrangement rules are defined.

In FIG. 6, the address converter ACON has five counters CNT1 through CNT5 that correspond to the first rank through the fifth rank and the outputs DO11 through DO15 of respective counters CNT1 through CNT5 are inputted in the lookup tables LUT1 through LUT5. A clock CK1 with a predetermined cycle is inputted in the counter CNT5 and then, the numeric values from 0 to a predetermined value (C5-1) are repeatedly outputted. An output carry out CO5 to be outputted in synchronized with the output of the counter CNT5, i.e., "0" is inputted in a counter CNT4 as a clock CK2 and the counter CNT4 repeatedly outputs the numeric values of 0 through the predetermined value (C4-1). An output carry out C04 to be outputted in synchronized with the output of the counter CNT4, i.e., "0" is inputted in a counter CNT3 as a clock CK3 and the counter CNT3 repeatedly outputs the numeric values of 0 through the predetermined value (C3-1). An output carry out CO3 to be outputted in synchronized with the output of the counter CNT3, i.e., "0" is inputted in a counter CNT2 as a clock CK4 and the counter CNT2 repeatedly outputs the numeric values of 0 through the predetermined value (C2-1). An output carry out C02 to be outputted in synchronized with the output of the counter CNT2, i.e., "0" is inputted in a counter CNT1 as a clock CK5 and the counter CNT1 repeatedly outputs the numeric values of 0 through the predetermined value (C1-1). The counter CNT1 generates the output with (C1×C2×C3×C4×C5) clocks as a cycle. This cycle is the same as the number of the bits of the initial address data row ADR0 and the blending address data row ADRC and corresponds to the data cycle of the output Dout.

The lookup table LUT5 converts the numeric values of 0 through (C5-1) into a predetermined address on the basis of the fifth rank data arrangement rule. The lookup table LUT4 converts the numeric values of 0 through (C4-1) into a predetermined address on the basis of the fourth rank data arrangement rule. The lookup table LUT3 converts the numeric values of 0 through (C3-1) into a predetermined address on the basis of the third rank data arrangement rule. The lookup table LUT2 converts the numeric values of 0 through (C2-1) into a predetermined address on the basis of the second rank data arrangement rule. The lookup table LUT1 converts the numeric values of 0 through (C1-1) into a predetermined address on the basis of the first rank data arrangement rule.

The outputs DO22 through DO25 of the lookup tables LUT2 through LUT5 are inputted in the multipliers MUL2 through MUL5, respectively. The multiplier MUL2 multiplies the output DO22 with C1 as a cycle of the carry out CO2. The multiplier MUL3 multiplies the output DO23 with a product of C1 and C2 as the cycles of the carry out CO2 and the carry out CO3. The multiplier MUL4 multiplies the output DO24 with a product of C1, C2 and C3 as the cycles of the carry out CO2, the carry out CO3 and the carry out CO4. The multiplier MUL5 multiplies the output DO25 with a product of C1, C2, C3 and C4 as the cycles of the carry out CO2, the carry out CO3 the carry out CO4 and the carry out CO5. The outputs DO32 through DO35 of the multipliers MUL2 through MUL5 and the output DO21 of the lookup table LUT1 are inputted in the adder ADD to be added and then, they are outputted as the blending address data row ADRC.

In this way, in accordance with the number of the ranks, the lookup tables are arranged in parallel, the cycle of the upper rank counter is multiplied by the output and the output from the uppermost rank lookup table is added to the outputs of the all multipliers, so that the address converter is capable of corresponding to complicated blending divided into any rank.

Alternatively, by dividing the lookup table, the size of this lookup table becomes smaller drastically compared to a lookup table to convert all addresses.

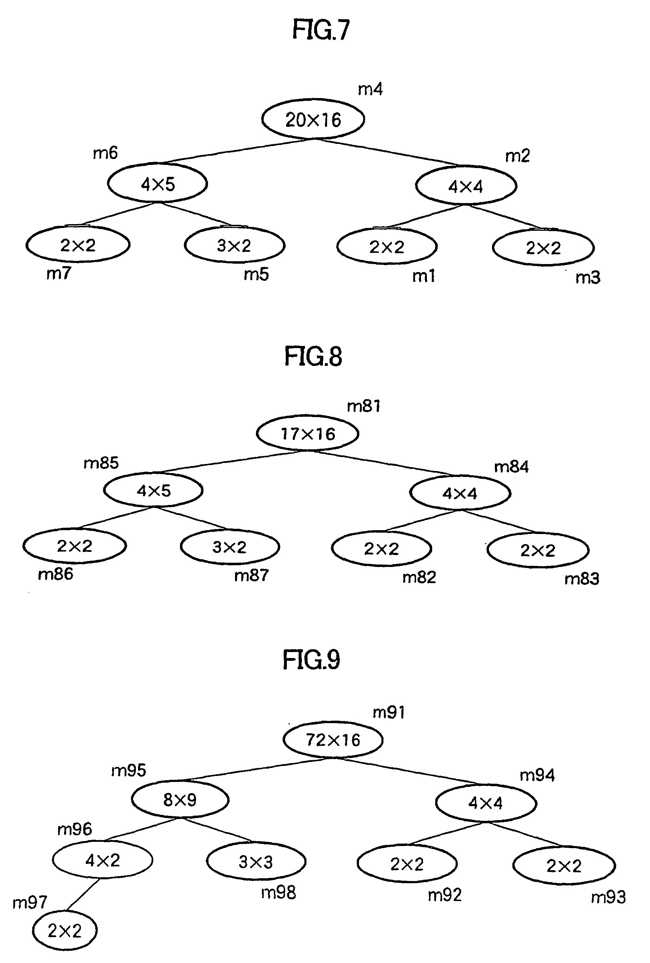

FIG. 7 is a conceptual illustration for illustrating a matrix layer to show a principle of the address conversion shown in FIG. 3. In FIG. 7, with respect to the number of the data 20×16 in a matrix m4 in FIG. 4, the sixteen rows thereof are defined by a matrix m2 comprising a matrix m1 and a matrix m3. On the other hand, the twenty lines of a matrix m4 are defined by a matrix m6 comprising of a matrix m5 and a matrix m7.

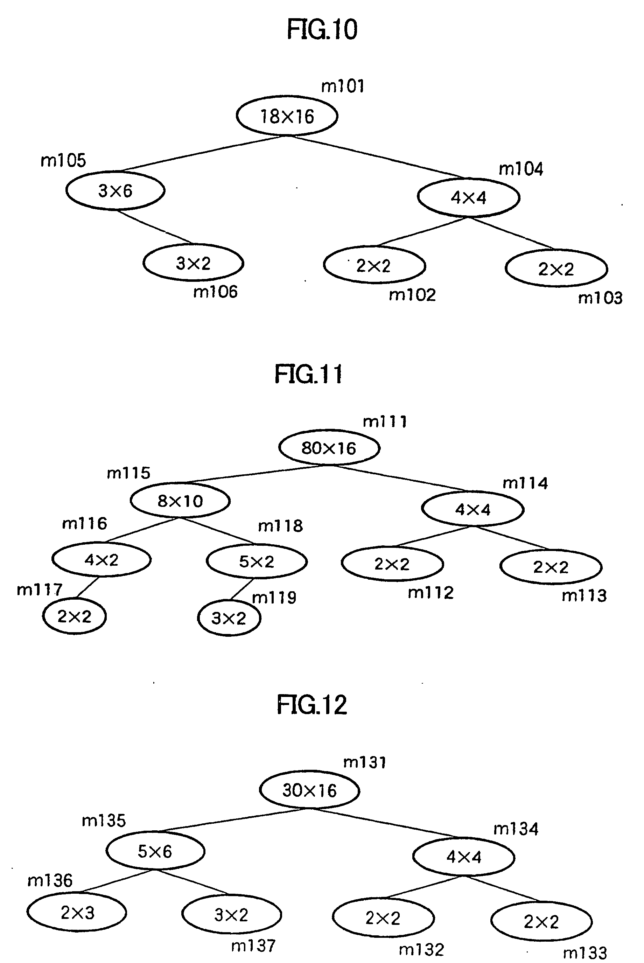

FIG. 8 is a conceptual illustration for illustrating a matrix layer to show a principle of other address conversion. In FIG. 8, with respect to a 17×16 matrix m81, the sixteen rows thereof are defined by a 4×4 matrix m84 comprising a 2×2 matrix m82 and a 2×2 matrix m83. On the other hand, the seventeen lines of the matrix m81 are defined by a portion of a 4×5 matrix m85, the four lines of the matrix m85 are defined by a 2×2 matrix m86 and the five lines of the matrix m85 are defined by a portion of a 3X2 matrix m87.

FIG. 9 is a conceptual illustration for illustrating a matrix layer to show a principle of other address conversion. In FIG. 9, with respect to a 72×16 matrix m91, the sixteen rows thereof are defined by a 4×4 matrix m94 comprising a 2×2 matrix m92 and a 2×2 matrix m93. Further, the seventy two lines of the matrix m91 are defined by a 8×9 matrix m95, the eight lines of the matrix m95 are defined by a 4×2 matrix m96 and the four lines of the matrix m96 are defined by a 2×2 matrix m97. Further, the nine rows of the matrix m95 are defined by a 3×3 matrix m98.

FIG. 10 is a conceptual illustration for illustrating a matrix layer to show a principle of other address conversion. In FIG. 10, with respect to a 18×16 matrix m101, the sixteen rows thereof are defined by a 4×4 matrix m104 comprising a 2×2 matrix m102 and a 4×4 matrix m103. Further, the eighteen lines of the matrix m101 are defined by a 3×6 matrix m105 and the six rows of the matrix m105 are defined by a 3X2 matrix m106.

FIG. 11 is a conceptual illustration for illustrating a matrix layer to show a principle of other address conversion. In FIG. 11, with respect to a 80×16 matrix mill, the sixteen rows thereof are defined by a 4×4 matrix m114 comprising a 2×2 matrix m112 and a 2×2 matrix m113. The eighty lines of the matrix m111 are defined by a 8×10 matrix m115 the eight lines of the matrix m115 are defined by a 4×2 matrix m116 and the four lines of the matrix m116 are defined by a 2×2 matrix m117 . Further, the ten rows of the matrix 115 are defined by a 5×2 matrix m118 and the five lines of the matrix m118 are defined by a portion of a 3×2 matrix m119.

FIG. 12 is a conceptual illustration for illustrating a matrix layer to show a principle of other address conversion. In FIG. 12, with respect to a 30×16 matrix m131, the sixteen rows thereof are defined by a 4×4 matrix m134 comprising a 2×2 matrix m132 and a 2×2 matrix m133. On the other hand, the thirty lines of the matrix m131 are defined by a 5×6 matrix m135, the five lines of the matrix m135 are defined by a portion of a 2×3 matrix m136 and the six rows of the matrix m135 are defined by a 3×2 matrix m137.

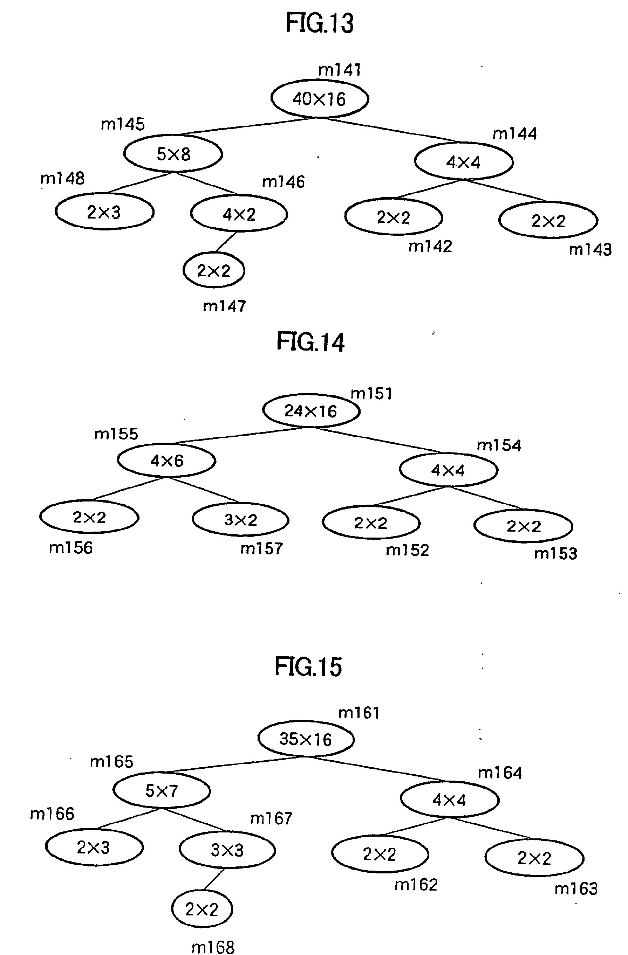

FIG. 13 is a conceptual illustration for illustrating a matrix layer to show a principle of other address conversion. In FIG. 13, with respect to a 40×16 matrix m141, the sixteen rows thereof are defined by a 4×4 matrix m144 comprising a 2×2 matrix m142 and a 2×2 matrix m143. The forty lines of the matrix m141 are defined by a 5×8 matrix m145, the eight rows of the matrix m145 are defined by a 4×2 matrix m146 and the four lines of the matrix m146 are defined by a 2×2 matrix m147. Further, the five lines of the matrix m145 are defined by a portion of a 2×3 matrix m148.

FIG. 14 is a conceptual illustration for illustrating a matrix layer to show a principle of other address conversion. In FIG. 14, with respect to a 24×16 matrix m151, the sixteen rows thereof are defined by a 4×4 matrix m154 comprising a 2×2 matrix m152 and a 2×2 matrix m153. On the other hand, the twenty four lines of the matrix m151 are defined by a 4×6 matrix m155, the four lines of the matrix m155 are defined by a 2×2 matrix m156 and the six rows of the matrix m155 are defined by a 3×2 matrix m157.

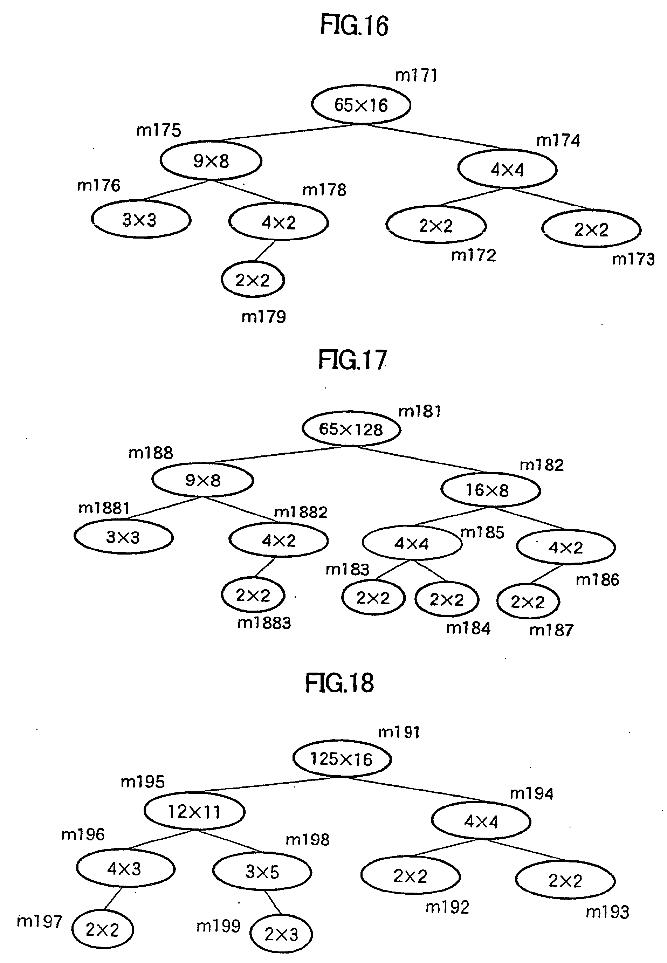

FIG. 15 is a conceptual illustration for illustrating a matrix layer to show a principle of other address conversion. In FIG. 15, with respect to a 35×16 matrix m161, the sixteen rows thereof are defined by a 4×4 matrix m164 comprising a 2×2 matrix m162 and a 2×2 matrix m163. The thirty five lines of the matrix m161 are defined by a 5×7 matrix m165, the five lines of the matrix m165 are defined by a portion of a 2×3 matrix m166 and the seven rows of the matrix m165 are defined by a portion of a 3×3 matrix m167. Further, the three lines of the matrix m167 are defined by a portion of a 2×2 matrix m168.

FIG. 16 is a conceptual illustration for illustrating a matrix layer to show a principle of other address conversion. In FIG. 16, with respect to a 65×16 matrix m171, the sixteen rows thereof are defined by a 4×4 matrix m174 comprising a 2×2 matrix m172 and a 2×2 matrix m173. The sixty five lines of the matrix m171 are defined by a portion of a 9×8 matrix m175, the nine lines of the matrix m175 are defined by a 3×3 matrix m176 and the eight rows of the matrix m175 are defined by a 4×2 matrix m178. Further, the four lines of the matrix m178 are defined by a 2×2 matrix m179.

FIG. 17 is a conceptual illustration for illustrating a matrix layer to show a principle of other address conversion. In FIG. 17, with respect to a 65×128 matrix m181, the 128 rows thereof are defined by a 16×8 matrix m182. The sixteen lines of the matrix m182 are defined by a 4×4 matrix m185 comprising a 2×2 matrix m183 and a 2×2 matrix m184. The eight lines of the matrix m182 are defined by a 4×2 matrix m186 and the four lines of the matrix m186 are defined by a 2×2 matrix m187. Further, the sixty five lines of the matrix m181 are defined by a portion of a 9×8 matrix m188, the nine lines of the matrix m188 are defined by a 3×3 matrix m1881 and the eight rows of the matrix m188 are defined by a 4×2 matrix m1882. The four lines of the matrix m1882 are defined by a 2×2 matrix m1883.

FIG. 18 is a conceptual illustration for illustrating a matrix layer to show a principle of other address conversion. In FIG. 18, with respect to a 125×16 matrix m191, the sixteen rows thereof are defined by a 4×4 matrix m194 comprising a 2×2 matrix m192 and a 2×2 matrix m193. The 125 lines of the matrix m191 are defined by a portion of a 12×11 matrix m195, the twelve lines of the matrix m195 are defined by a 4×3 matrix m196 and the four lines of the matrix m196 are defined by a 2×2 matrix m197. Further, the eleven rows of the matrix m195 are defined by a portion of a 3×5 matrix m198 and the five rows of the matrix m198 are defined by a portion of a 3×2 matrix m199.

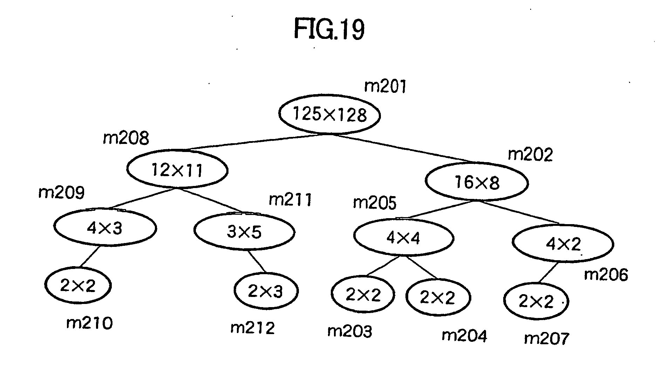

FIG. 19 is a conceptual illustration for illustrating a matrix layer to show a principle of other address conversion. In FIG. 19, with respect to a 125×128 matrix m201, the one hundred twenty eight rows thereof are defined by a 16×8 matrix m202. The sixteen lines of the matrix 202 are defined by a 4×4 matrix m205 comprising a 2×2 matrix m203 and a 2×2 matrix m204. The eight rows of the matrix m202 are defined by a 4×2 matrix m206 and the four lines of the matrix m206 are defined by a 2×2 matrix m207. Further, the 125 lines of the matrix m201 are defined by a portion of a 12×11 matrix m208, the twelve lines of the matrix m208 are defined by a 4×3 matrix m209 and the four lines of the matrix m209 are defined by a 2×2 matrix m210. The eleven rows of the matrix m208 are defined by a portion of a 3×5 matrix m211 and the five rows of the matrix m211 are defined by a portion of a 2×3 matrix m212.

### INDUSTRIAL APPLICABILITY

As described above, according to the present invention, it is possible to provide an address converter, an interleaver and a deinterleaver, which are small-sized and power saving.

## Claims

1. An address converter comprising:
an upper rank lookup table to sequentially output not more than m pieces of elements equivalent to a predetermined line of a m×n matrix having the number of the elements not less than the length of a predetermined address data row;
a lower rank lookup table to sequentially and repeatedly output n pieces of elements equivalent to said predetermined row of said m×n matrix not more than m times; and
an adder to add the output of said upper rank lookup table and the output of said lower rank lookup table and output said predetermined address data row.

2. An address converter according to claim 1,
wherein said address converter further comprises with a multiplier to multiply the output with m and input it in said adder instead of directly inputting the output of said lower rank lookup table in said adder.

3. An address converter according to claim 1 or 2,
wherein said adder adds the outputs of not less than three lookup tables.

4. An interleaver comprising:
said address converter according to claim 1,
a first register to hold a data row to be blended; and
a second register to register a data row of said first register in an order of the blending address data row on the basis of said blending address data row when an initial address data row is inputted in said address converter.

5. A deinterleaver comprising:
said address converter according to claim 1,
a second register to hold a data row to be blended; and
a first register to register a data row of said second register in an order of the initial address data row on the basis of the blending address data row when said initial address data row is inputted in said address converter.
